# EUROPEAN PATENT SPECIFICATION

(11) **EP 2 023 275 B1**
(45) Date of publication and mention of the grant of the patent: **27.04.2011**
(21) Application number: 07743469.4
(22) Date of filing: 16.05.2007
(51) Int. Cl.: G06K 19/07, G06K 19/077, H01F 38/14, H01Q 1/50, H01Q 23/00

(54) **RADIO FREQUENCY IC DEVICE AND COMPOSITE COMPONENT FOR RADIO FREQUENCY IC DEVICE**
HOCHFREQUENZ-IC-ANORDNUNG UND ZUSAMMENGESETZTE KOMPONENTE FÜR EINE HOCHFREQUENZ-IC-ANORDNUNG
DISPOSITIF À CIRCUITS INTÉGRÉS RADIOFRÉQUENCE ET SES COMPOSANT COMPOSITE

(30) Priority: 01.06.2006 JP 2006153703; 01.09.2006 JP 2006238372
(43) Date of publication of application: 11.02.2009
(73) Proprietor: Murata Manufacturing Co. Ltd., Nagaokakyo-shi, Kyoto 617-8555 (JP)
(72) Inventor: KATO, Noboru, Nagaokakyo-shi, Kyoto 617-8555 (JP); DOKAI, Yuya, Nagaokakyo-shi, Kyoto 617-8555 (JP); ISHINO, Satoshi, Nagaokakyo-shi, Kyoto 617-8555 (JP)
(74) Representative: Schenk, Markus
(86) International application number: PCT/JP2007/060034
(87) International publication number: WO 2007/138857

(56) References cited:
- EP-A- 0 942 441
- EP-A- 1 031 939
- JP-A- 08 087 580
- JP-A- 11 149 536
- JP-A- 11 261 325
- JP-A- 2000 510 271
- JP-A- 2005 275 870
- US-A1- 2002 011 967
- US-A1- 2006 043 198
- US-A1- 2006 044 769

## Description

### Technical Field

The present invention relates to wireless integrated circuit (IC) devices. More particularly, the present invention relates to a wireless IC device used in a radio frequency identification (RFID) system and a wireless-IC-device composite part used in the wireless IC device.

### Background Art

In recent years, RFID systems have been developed as management systems of articles. In a typical RFID system, a reader-writer generating an induction field communicates with a wireless tag (hereinafter referred to as a wireless IC device) that is appended to an article and that stores certain information in a non-contact manner to transmit information.

Wireless IC devices used in the RFID systems are disclosed in, for example, Patent Documents 1 and 2.

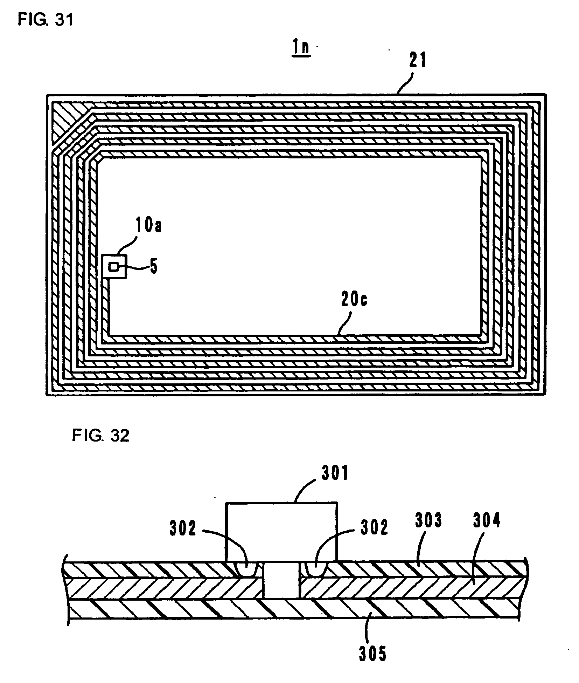

Specifically, a wireless IC device shown in Fig. 32 is disclosed, in which an air-core type antenna pattern 304 formed of a aluminum foil, a wireless IC chip 301 directly connected to certain positions on the antenna pattern 304 via Au bumps 302, and a resin layer 303 provided so as to cover the Au bumps 302 in order to ensure the bonding strength of the wireless IC chip 301 are provided on a support film 305 made of polyethylene terephthalate (PET).
Patent Document 1: US Patent No. 6,406,990
Patent Document 2: US Patent No. 6,664,645

In this wireless IC device, the wireless IC chip 301 is directly connected to the antenna pattern 304 via the Au bumps 302 and it is necessary to position the wireless IC chip 301 on the support film 305 having an area that is much larger than that of the wireless IC chip 301. However, it is very difficult to accurately mount the minute wireless IC chip 301 on the large support film 305, and there is a problem in that the resonant frequency characteristics of the antenna are varied if the wireless IC chip 301 is displaced or the sizes of the Au bumps 302 are varied. In addition, since the frequency characteristics of the wireless IC device are substantially determined by the shape or size of the antenna pattern 304, the frequency characteristics are apt to vary if the antenna pattern 304 is curled or is sandwiched between dielectric bodies (for example, the antenna pattern 304 is sandwiched in a book).

Furthermore, the resonant frequency of signals transmitted or received by the wireless IC device is basically determined by the electrical length of the antenna pattern. For example, when transmission-reception signals within a bandwidth of 13.5 MHz are processed in the air-core type antenna pattern, the antenna pattern is increased in size because an inductance of about 4.5 µH is needed.

US 2006/043198 A1 discloses an RFID device, such as an RFID tag or label. The RFID device includes a combined reactive coupler electrically coupling a transponder chip to an antenna. The combined reactive coupler includes a magnetic coupler and a capacitive coupler. The magnetic coupler and the reactive coupler may have respective coupling elements on both an interposer and on an antenna substrate. A high permeability material may be placed in proximity to the magnetic coupling elements.

JP 2000510271 A discloses a transmission module for contactless transmission of data between a chip and a reading device with a coil arrangement comprising a coupling element and at least one antenna coil that are electrically interconnected, wherein said coupling element is used to produce inductive coupling with a transponder coil which is electrically connected to the chip, and the antenna coil is used to enable connection to the reading device. The coupling element embodied as a coupling coil and the antenna coil are configured differently with respect to the coil parameters affecting coil impedance.

### Disclosure of Invention

### Problems to be Solved by the Invention

In order to resolve the above problems, an object of the present invention is to provide a small wireless IC device having stable frequency characteristics and a wireless-IC-device composite part.

This object is achieved by a wireless-IC-device composite part according to claim 1 and a wireless IC device according to claim 2.

### Advantages

According to the present invention, since the wireless IC chip is mounted on the feed circuit board, it is possible to accurately mount the wireless IC chip on the board. Since the feed circuit board is electromagnetically coupled to the radiation plate, it is possible to easily mount the composite part composed of the wireless IC chip and the feed circuit board on the radiation plate by arranging the composite part directly on the radiation plate or arranging the composite part adjacent to the radiation plate.

In addition, since the frequencies of transmission and reception signals are substantially determined by the feed circuit provided in the feed circuit board, the frequency characteristics are not substantially varied even if the radiation plate is curled or is sandwiched between a dielectric body, thus achieving the stable frequency characteristics.

Furthermore, since the inductance element composing the feed circuit is formed in the high-permeability magnetic body, it is possible to increase the Q value of the inductance element, to achieve the stable frequency characteristics even if the inductance element is reduced in size, and to reduce the size of the feed circuit board and the wireless IC device.

### Brief Description of Drawings

[Fig. 1] Fig. 1 is a perspective view showing a wireless IC device according to a first embodiment of the present invention.
[Fig. 2] Fig. 2 is a cross-sectional view of the wireless IC device according to the first embodiment.
[Fig. 3] Fig. 3 is an equivalent circuit of the wireless IC device according to the first embodiment.
[Fig. 4] Fig. 4 is an exploded perspective view showing a feed circuit board in the wireless IC device according to the first embodiment.
[Fig. 5] Fig. 5 is a cross-sectional view showing a wireless IC device according to a second embodiment of the present invention.
[Fig. 6] Fig. 6 is an equivalent circuit of the wireless IC device according to the second embodiment.
[Fig. 7] Fig. 7 is an exploded perspective view showing a feed circuit board in the wireless IC device according to the second embodiment.
[Fig. 8] Fig. 8 is an equivalent circuit of a modification of the wireless IC device according to the second embodiment.
[Fig. 9] Fig. 9 is an external perspective view of a wireless-IC-device composite part according to a third embodiment of the present invention.
[Fig. 10] Fig. 10 is an exploded perspective view showing a feed circuit board in the wireless IC device according to the third embodiment.
[Fig. 11] Fig. 11 is an equivalent circuit of the wireless IC device according to the third embodiment.
[Fig. 12] Fig. 12 is an exploded perspective view showing in detail the feed circuit board in the wireless IC device according to the third embodiment.
[Fig. 13] Fig. 13 includes external perspective views showing examples of arrangement of a radiation plate in the wireless IC device according to the third embodiment.
[Fig. 14] Fig. 14 is an exploded perspective view of a wireless IC device (a wireless-IC-device composite part) according to a fourth embodiment of the present invention.
[Fig. 15] Fig. 15 is an external perspective view of the wireless IC device according to the fourth embodiment.
[Fig. 16] Fig. 16 is an exploded perspective view of a wireless IC device (a wireless-IC-device composite part) according to a fifth embodiment of the present invention.
[Fig. 17] Fig. 17 is an external perspective view of the wireless IC device according to the fifth embodiment.
[Fig. 18] Fig. 18 is an external perspective view of the wireless IC device (the wireless-IC-device composite part) according to the fifth embodiment.
[Fig. 19] Fig. 19 is an exploded perspective view of a wireless IC device (a wireless-IC-device composite part) according to a sixth embodiment of the present invention.
[Fig. 20] Fig. 20 is an external perspective view of the wireless IC device according to the sixth embodiment.
[Fig. 21] Fig. 21 is an exploded perspective view of a wireless IC device (a wireless-IC-device composite part) according to a seventh embodiment of the present invention.
[Fig. 22] Fig. 22 is an external perspective view of the wireless IC device according to the seventh embodiment.
[Fig. 23] Fig. 23 is an exploded perspective view of a wireless IC device (a wireless-IC-device composite part) according to an eighth embodiment of the present invention.
[Fig. 24] Fig. 24 is an external perspective view of the wireless IC device (the wireless-IC-device composite part) according to the eighth embodiment.
[Fig. 25] Fig. 25 is an external perspective view of a modification of the wireless IC device (the wireless-IC-device composite part) according to the eighth embodiment.
[Fig. 26] Fig. 26 is a perspective view of a wireless IC device according to a ninth embodiment of the present invention.
[Fig. 27] Fig. 27 is a perspective view of a wireless IC device according to a tenth embodiment of the present invention.
[Fig. 28] Fig. 28 is an external perspective view of a wireless IC device according to a first application of the present invention.
[Fig. 29] Fig. 29 is an external perspective view of a wireless IC device according to a second application of the present invention.
[Fig. 30] Fig. 30 is an external perspective view of a wireless IC device according to a third application of the present invention.
[Fig. 31] Fig. 31 is a plan view of a wireless IC device according to a fourth application of the present invention.
[Fig. 32] Fig. 32 is a schematic cross-sectional view showing an example of a wireless IC device in related art.

### Best Modes for Carrying Out the Invention

A wireless IC device according to the present invention includes (1) a wireless IC chip, (2) a feed circuit board having the wireless IC chip mounted thereon and including a feed circuit including an inductance element, and (3) a radiation plate electromagnetically coupled to the inductance element in the feed circuit. In particular, the wireless IC device has a characteristic structure in which a high-permeability magnetic body made of a high-permeability magnetic material is formed in at least part of the feed circuit board and at least part of the inductance element is provided in the high-permeability magnetic body.

Specifically, in the wireless IC device of the present invention, the wireless IC chip is mounted on the feed circuit board and is connected to the radiation plate via the feed circuit board. Since the feed circuit board has an area considerably smaller than that of the radiation plate, it is possible to accurately mount the wireless IC chip on the feed circuit board.

The feed circuit board includes the feed circuit having a function of determining the center frequency of transmission and reception signals, the function of matching the impedance of the wireless IC chip to the impedance of the radiation plate, and so on. The center frequency of transmission signals and/or the center frequency of reception signals are substantially determined by the feed circuit in the feed circuit board. In other words, since the frequencies of the transmission and reception signals are determined in the feed circuit board on which the wireless IC chip is accurately mounted, the frequency characteristics are not varied to achieve the stable frequency characteristics regardless of the shape and size of the radiation plate and the position where the radiation plate is arranged, for example, even if the wireless IC device is curled or is sandwiched between a dielectric body. The phrase "substantially determines" is used because the frequencies can slightly shifted due to, for example, the positional relationship between the feed circuit board and the radiation plate.

Since the radiation plate is electromagnetically coupled to the feed circuit in the feed circuit board, it is possible to supply a transmission signal from the feed circuit board to the radiation plate and/or to supply a reception signal from the radiation plate to the feed circuit board even without bump connection by using Au etc., thus greatly facilitating the connection between the radiation plate and the feed circuit board. As a result, the manufacturing process of the wireless IC device can be simplified, the variation in the frequency characteristics is reduced, the manufacturing efficiency is improved, and the stable frequency characteristics can be ensured. In other words, it is not necessary to use ultrasonic bonding using the Au bump and it is sufficient to use an adhesive, such as resin, to connect the feed circuit board to the radiation plate. Particularly in this case, a magnetic adhesive can be used. The feed circuit board may be arranged adjacent to the radiation plate, instead of directly connecting the feed circuit board to the radiation plate.

In the wireless IC device of the present invention, since the inductance element composing the feed circuit is formed in the high-permeability magnetic body made of a high-permeability magnetic material, it is possible to increase the Q value of the inductance element. Accordingly, it is possible to provide the element having a sufficient inductance even if the inductance element is reduced in size to achieve the stable frequency characteristics.

It is preferred that the inductance element composing the feed circuit be formed of a coil inductor pattern, such as a spiral or helical inductor pattern, in the wireless IC device of the present invention. It is also preferred that the inductor pattern be formed in the feed circuit board such that the winding axis of the inductor pattern is perpendicular to the radiation plate. In other words, it is preferred that the magnetic flux generated in the direction of the winding axis of the inductor pattern be used to couple the feed circuit to the radiation plate.

It is preferred that the feed circuit board have a nonmagnetic body made of a low-permeability magnetic material or a nonmagnetic material formed therein and that the winding part adjacent to the radiation plate, in the inductor pattern, be formed in the nonmagnetic body. The formation of at least the winding part adjacent to the radiation plate, in the inductor pattern, in the nonmagnetic body improves the transmission efficiency of the signals from the feed circuit to the radiation plate and the transmission efficiency of the signals from the radiation plate to the feed circuit without trapping the magnetic flux generated in the inductor pattern in the high-permeability magnetic body.

The permeabilities of the high-permeability magnetic body and the low-permeability magnetic body are not specifically restricted, and it is sufficient to set the permeabilities so as to make any relative difference between the permeability of the high-permeability magnetic body and that of the low-permeability magnetic body. Specifically, a material having a permeability of 15 or higher is preferably used for the high-permeability magnetic body and a material having a permeability of lower than 15 is preferably used for the low-permeability magnetic body.

The inductance element composing the feed circuit may be formed of a coil inductor pattern, such as a spiral or helical inductor pattern. This inductor pattern may be formed in the feed circuit board such that the winding axis of the inductor pattern is parallel to the radiation plate. In other words, the magnetic flux generated in a direction perpendicular to the winding axis of the inductor pattern may be used to couple the feed circuit to the radiation plate.

It is preferred that the inductance element in the feed circuit board be formed of a coil inductor pattern, that is, be formed of a coil electrode pattern. This is because a coil electrode pattern, such as a spiral or helical electrode pattern, can be used to easily control the magnetic flux and to facilitate the design particularly in a relatively lower bandwidth, for example, in a bandwidth of 13.5 MHz. In a higher frequency band, a meander pattern may be used. Since the feed circuit is electromagnetically coupled to the radiation plate, it is preferred not to inhibit a variation in the magnetic flux generated by the inductor pattern, that is, the coil electrode pattern in the feed circuit board. For example, it is desirable that an opening be formed in a part (a power feed part) of the radiation plate, where the magnetic flux generated by the inductor pattern is received. This improves the transmission efficiency of the signal energy and reduces the variation in frequency due to the displacement occurring when the feed circuit board is adhered to the radiation plate. In addition, the winding width of the coil electrode pattern is preferably formed so as to be gradually increased toward the radiation plate because the transmission efficiency of the signals is improved in this case.

It is preferred that the feed circuit provided in the feed circuit board include the inductance element and a capacitance element that compose an LC resonant circuit having a predetermined resonant frequency. This LC resonant circuit can determine the center frequency of the transmission and reception signals and can match the impedance of the wireless IC chip to that of the radiation plate. The center frequencies of the transmission signals and/or the reception signals can be substantially determined by the resonant frequency of the LC resonant circuit on the feed circuit board.

The LC resonant circuit may be an LC series resonant circuit or an LC parallel resonant circuit. Alternatively, the LC resonant circuit may include multiple LC series resonant circuits or multiple LC parallel resonant circuits. Structuring the resonant circuit as a lumped constant resonant circuit composed of a capacitor pattern and an inductor pattern allows the resonant circuit to be easily designed in a lower bandwidth in which the transmission and reception signals have frequencies of 5 GHz or lower and makes it difficult to be affected by other elements, such as the radiation plate. When the multiple resonant circuits are used, magnetically coupling the resonant circuits to each other, particularly, magnetically coupling the inductor elements to each other allows the frequency band to be broadened.

The capacitance element composing the feed circuit may be included in the feed circuit board as a capacitor pattern or may be mounted on the feed circuit board as a surface mount part, such as a chip ceramic capacitor.

It is preferred that the capacitance element composing the feed circuit be provided downstream of the wireless IC chip and be arranged between the wireless IC chip and the inductance element in order to protect the wireless IC chip from a surge and so on.

The capacitor pattern and the inductor pattern provided on the feed circuit board are preferably arranged in parallel to and adjacent to the radiation plate. In this case, the electrical coupling by the capacitor pattern in the feed circuit, in addition to the magnetic coupling by the inductor pattern in the feed circuit, can be used to couple the radiation plate to feed circuit board, thus improving the transmission efficiency of the energy of the transmission and reception signals. A reflector and/or a waveguide may be arranged in order to provide the directivity of the magnetic flux to the part where the magnetic flux is generated by the inductor pattern. The provision of the reflector and/or the waveguide allows the radiation characteristics and the directivity from the feed circuit to the radiation plate to be easily adjusted. As a result, it is possible to exclude external electromagnetic effects to achieve the stable resonance characteristics.

Since the electromagnetic coupling between the radiation plate and the inductor pattern in the feed circuit is mainly used to connect the radiation plate to the feed circuit board, the radiation plate is preferably made of a magnetic metal material, such as iron. However, the material of the radiation plate is not restricted to the magnetic metal material and a nonmagnetic metal material, such as silver or copper, may be used for the radiation plate. In addition, the radiation plate may be formed by printing metal paste containing a metal material or metal-containing ink on an article or a metal part of an article may be used as the radiation plate. The radiation plate may have various shapes, such as a thin film shape, a rod shape, a spiral coil shape, a circular shape, or a cylindrical shape. The size of the radiation plate can be appropriately adjusted to appropriately adjust the transmission distance of signals.

In the feed circuit board, at least part of the inductance element, preferably, the main part thereof should be formed in the high-permeability magnetic body. Although the high-permeability magnetic body preferably has a layered structure because of the manufacturing method of the feed circuit board, the structure of the high-permeability magnetic body is not restricted to the layered structure. In addition, the feed circuit board is preferably a multilayer board in which dielectric layers etc. having a predetermined permittivity are layered on the high-permeability magnetic layers serving as the high-permeability magnetic body. In this case, the capacitor pattern and the inductor pattern are formed on the surface and/or inside of the multilayer board. Structuring the resonant circuit as the multilayer board allows the elements (for example, the electrode pattern) composing the resonant circuit to be formed not only on the surface of the board but also inside of the board to reduce the size of the board. In addition, the degree of freedom of the layout of the resonant circuit elements is improved and the performance of the resonant circuit is also improved. The multilayer board may be a resin multilayer board in which multiple resin layers are layered or may be a ceramic multilayer board in which multiple ceramic layers are layered. Alternatively, the multilayer board may be a thin-film multilayer board using a thin film forming technology. In the case of the ceramic multilayer board, it is preferred that the ceramic layers be made of a low-temperature sintering ceramic material that can be fired concurrently with a low melting point metal, such as silver or copper. This is because the resonant circuit can be made of the silver or copper having a lower resistance.

Furthermore, the feed circuit board may be a single-layer board formed of a high-permeability magnetic body. In this case, the capacitor pattern and/or the inductor pattern are formed on the surface of the single-layer board. The single-layer board may be made of resin or ceramic, as long as it is a high-permeability magnetic body. The capacitance generated by the capacitor pattern may be generated between planer electrodes formed on the top and bottom surfaces of the single-layer board or may be generated between electrodes arranged in parallel on one surface of the single-layer board.

In particular, the feed circuit board is preferably a ceramic multilayer board in which multiple ceramic layers are layered. In this case, it is possible to accurately include the capacitor pattern and the inductor pattern and, for example, a magnetic ceramic material can be used to generate an inductor pattern having a desired inductance. Since the ceramic board is rigid, it is possible to mechanically protect the wireless IC chip and to easily mount the wireless IC chip.

It is preferred that the feed circuit board be a rigid board and the radiation plate be formed of a flexible metal film. In addition, it is preferred that the flexible metal film be held on a flexible resin film. The wireless IC chip can be stably mounted on the rigid board. In contrast, the radiation plate is preferably formed of a flexible metal film. The flexible radiation plate allows the wireless IC device to be adhered to an article of any shape. The holding of the flexible metal film on a flexible resin film allows the wireless IC device itself to be easily dealt with. In particular, if all of the wireless IC chip, the feed circuit board, and the radiation plate are covered with a film, they can be protected from the external environment. The feed circuit board may not necessarily be rigid and may be formed as a flexible board made of an organic resin material (for example, polyimide or liquid crystal polymer).

The electrical length of the radiation plate is preferably an integer multiple of the half-wavelength of the resonant frequency of the transmission and reception signals. The radiation plate of the electrical length that is an integer multiple of the half-wavelength of the resonant frequency maximizes the gain. However, since the frequency is substantially determined by the resonant circuit, the electrical length of the radiation plate may not necessarily be an integer multiple of the half-wavelength of the resonant frequency. This is a great advantage, compared with a case where the radiation plate is an antenna element having a predetermined resonant frequency.

The present invention provides a wireless-IC-device composite part including (1) a wireless IC chip and (2) a feed circuit board having the wireless IC chip mounted thereon and including a feed circuit including an inductance element. A high-permeability magnetic body made of a high-permeability magnetic material is formed in at least part of the feed circuit board and at least part of the inductance element is provided in the high-permeability magnetic body. Adhering this composite part to the metal part of an arbitrary article allows the article to be used as a wireless IC device.

In the wireless IC device according to the present invention, the radiation plates may be arranged on the top and bottom surfaces of the feed circuit board. Sandwiching the feed circuit board between the two radiation plates allows the energy radiated from the feed circuit to be transmitted to the respective radiation plates on the top and bottom surfaces of the feed circuit board, thus increasing the gain.

The connection between the wireless IC chip and the feed circuit board can be achieved by various manners. For example, a chip-side electrode pattern may be provided on the wireless IC chip, a circuit-board-side electrode pattern (hereinafter sometimes referred to as a first circuit-board-side electrode pattern) may provided on the feed circuit, board, and the chip-side electrode pattern may be DC-connected to the first circuit-board-side electrode pattern. In this case, the chip-side electrode pattern can be DC-connected to the first circuit-board-side electrode pattern with solder, conductive resin, or a gold bump.

Alternatively, the chip-side electrode pattern may be capacitively or magnetically coupled to the first circuit-board-side electrode pattern. In the case of the capacitive or magnetic coupling, it is not necessary to use the solder or the conductive resin and the wireless IC chip can be adhered to the feed circuit board with an adhesive, such as resin. In this case, it is not necessary for the chip-side electrode pattern and the first circuit-board-side electrode pattern to be formed on the surface of the wireless IC chip and the surface of the feed circuit board, respectively. For example, a resin film may be formed on the surface of the chip-side electrode pattern or the first circuit-board-side electrode pattern may be formed on an inner layer of the multilayer board.

In the case of the capacitive coupling, the area of the first circuit-board-side electrode pattern is preferably larger than that of the chip-side electrode pattern. Even if the positional accuracy is slightly varied when the wireless IC chip is mounted on the feed circuit board, the variation in the capacitance generated between both of the electrode patterns is alleviated. In addition, it is difficult to form the large electrode pattern on the small wireless IC chip whereas there is no problem to form the large electrode pattern on the feed circuit board because the feed circuit board is relatively large.

Since the required accuracy at which the wireless IC chip is mounted on the feed circuit board in the case of the magnetic coupling is not so high, compared with the case of the capacitive coupling, it is easy to mount the wireless IC chip on the feed circuit board. In addition, it is preferred that the chip-side electrode pattern and the first circuit-board-side electrode pattern be coil electrode patterns. The coil electrode patterns, such as spiral or helical electrode patterns, can be easily designed. At higher frequencies, it is effective to adopt meander electrode patterns.

In the wireless IC device according to the present invention, when a both-side (both-end) open radiation plate including a radiation part that exchanges transmission and reception signals with external devices and a power feed part that exchanges transmission and reception signals with the feed circuit (the resonant circuit) is adopted, the presence of the radiation part increases the antenna gain and a sufficient gain can be achieved even with a small feed circuit pattern. In addition, the wireless IC device operates with a sufficient distance from a reader-writer and can be sufficiently used even in frequency bands higher than the UHF frequency band. Furthermore, the resonant frequency is substantially determined by the feed circuit pattern, the shape of the radiation part can be freely set, the gain can be adjusted by varying the size or the like of the radiation part, and the center frequency can be fine-tuned by the shape or the like of the radiation part.

At least part of the power feed part of the radiation plate may be arranged so as to be positioned in the projection plane of the inductor pattern composing the feed circuit and it may be sufficient for the area of the power feed part to be smaller than that of the projection plane of the inductor pattern. The projection plane means a plane surrounded by the outline of the inductor pattern and the area of the power feed part means the area of the metal part of the radiation plate. Since the power feed part of the radiation plate is coupled to the inductor pattern via the magnetic field, the part blocking the magnetic flux of the feed circuit pattern is reduced in size to improve the transmission efficiency of signals when the area of the power feed part is smaller than that of the projection plane of the inductor pattern.

The power feed part may be formed such that the longitudinal length of the power feed part is across the projection plane of the inductor pattern, for example, may be linearly formed. The radiation parts of the radiation plate may be provided at both ends of the power feed part or the radiation part thereof may be provided at one end of the power feed part. The provision of the radiation parts at both ends of the power feed part increases the capacitive coupling with the inductor pattern. The provision of the radiation part only at one end of the power feed part increase the magnetic coupling with the inductor pattern to increase the gain.

Multiple feed circuit patterns including inductor patterns and capacitor patterns may be formed on the feed circuit board. In this case, the power feed part of the radiation plate is preferably arranged so as to be positioned among the projection planes of the multiple feed circuit patterns. The power feed part may be formed such that the longitudinal length of the power feed part is across the projection planes of the multiple feed circuit patterns, for example, may be linearly formed. The arrangement of the power feed part among the multiple feed circuit patterns increases the amount of power supply between the power feed part and the feed circuit patterns.

The radiation plate may include a radiation part that is formed in the x-y plane and that extends to the directions of the x axis and the y axis. In this case, it is possible to receive a circularly polarized wave to increase the antenna gain. Alternatively, the radiation plate may include a radiation part that extends to the directions of the x axis, the y axis, and the z axis in the x-y-z plane. The three-dimensional extension of the radiation plane allows efficient transmission and reception from any direction.

The radiation part of the radiation plate may extend perpendicular to the plane on which the feed circuit pattern is formed. Specifically, the power feed part may be provided in a plane that is at the tip of a needle radiation part and that is perpendicular to the radiation part and the power feed part may be coupled to the feed circuit pattern via the electric field or the magnetic field. In this case, it is possible to mount the wireless IC device to an article in a manner in which the needle radiation part is inserted into the article.

The power feed part and the feed circuit pattern may be covered with a magnetic body. In this case, it is possible to prevent leakage of the electromagnetic energy. As a result, the level of coupling between the power feed part and the feed circuit pattern is increased to increase the antenna gain.

### Embodiments

Embodiments of a wireless IC device according to the present invention will herein be described with reference to the attached drawings. The same reference numerals are used to identify the parts and components common to the embodiments described below and duplicated descriptions of such parts and components are omitted herein.

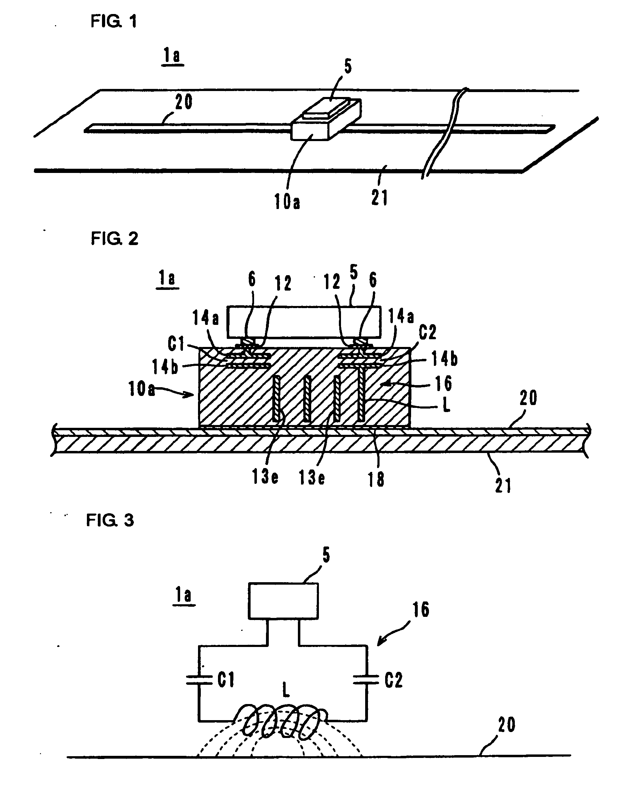

### (First Embodiment, Refer to Figs. 1 to 4)

A wireless IC device la according to a first embodiment is provided with a monopole type radiation plate. As shown in Figs. 1 and 2, the wireless IC device 1a includes a wireless IC chip 5, a feed circuit board 10a having the wireless IC chip 5 mounted on the top surface thereof, and a radiation plate 20 to which the feed circuit board 10a is adhered. The wireless IC chip 5 includes clock circuits, logic circuits, and memory circuits and has necessary information stored therein. The wireless IC chip 5 is directly DC-connected to a feed circuit 16 included in the feed circuit board 10a.

The feed circuit board 10a is a ceramic multilayer board made of a magnetic ceramic material having a high permeability. The feed circuit 16 is a circuit for supplying a transmission signal having a predetermined frequency to the radiation plate 20 and/or a circuit for selecting a reception signal having a predetermined frequency from signals received with the radiation plate 20 and supplying the reception signal to the wireless IC chip 5. The feed circuit 16 is provided with a resonant circuit resonating at the frequencies of the transmission and reception signals.

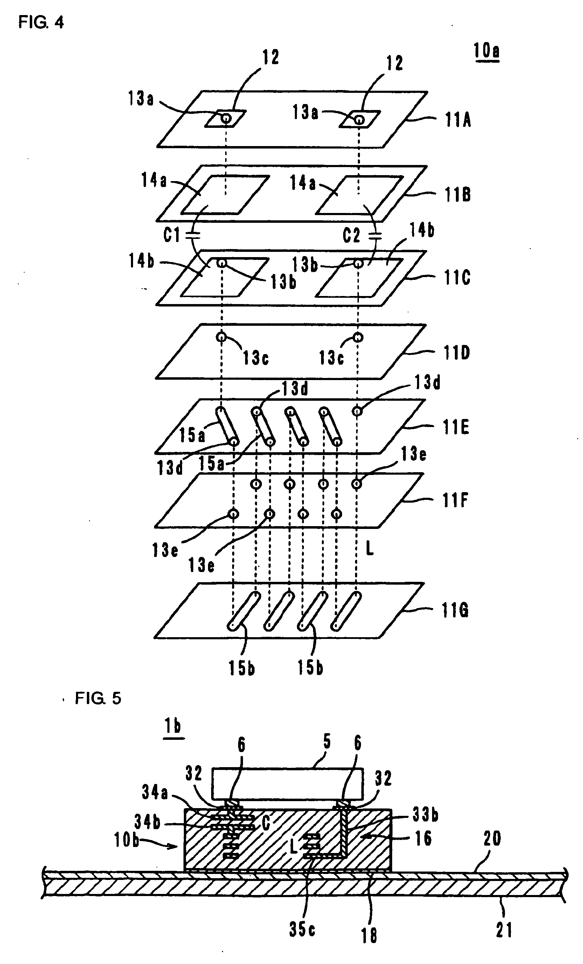

The feed circuit board 10a includes the feed circuit 16 composed of a lumped constant LC series resonant circuit including a helical inductance element L and capacitance elements C1 and C2, as shown in Figs. 2 and 3. Specifically, as shown in Fig. 4, the feed circuit board 10a is manufactured by layering, attaching by pressure, and firing ceramic sheets 11A to 11G formed of high-permeability magnetic bodies. The feed circuit board 10a includes the sheet 11A on which connection electrodes 12 and via-hole conductors 13a are formed, the sheet 11B on which capacitance electrodes 14a are formed, the sheet 11C on which capacitance electrodes 14b and via-hole conductors 13b are formed, the sheet 11D on which via-hole conductors 13c are formed, the sheet 11E on which conductive patterns 15a and via-hole conductors 13d are formed, the sheet or sheets 11F on which via-hole conductors 13e are formed, and the sheet 11G on which conductive patterns 15b are formed. Each of the ceramic sheets 11A to 11G can be easily manufactured by a manufacturing process for a multilayer board, such as a sheet layering method or a thick film printing method conventionally used.

Layering the above ceramic sheets 11A to 11G forms the helical inductance element L whose winding axis is parallel to the radiation plate 20 and the capacitance elements C1 and C2 in which the capacitance electrodes 14b are connected to both ends of the inductance element L and the capacitance electrodes 14a are connected to the connection electrodes 12 via the via-hole conductors 13a. The connection electrodes 12, which are circuit-board-side electrode patterns, are DC-connected to chip-side electrode patterns (not shown) of the wireless IC chip 5 via solder bumps 6.

Specifically, a transmission signal is supplied from the inductance element L, which is a coil electrode pattern among the elements composing the feed circuit 1, and to the radiation plate 20 through the magnetic field, and a reception signal from the radiation plate 20 is supplied to the inductance element L through the magnetic field. Accordingly, it is desirable that, among the inductance element L and the capacitance elements C1 and C2 composing the resonant circuit, the inductance element L be arranged so as to be close to the radiation plate 20 in the feed circuit board 10a.

The radiation plate 20 may be a magnetic body made of iron etc. or may be a long body made of a nonmagnetic material, such as an aluminum foil or a copper foil, that is, a both-end open metallic body. The radiation plate 20 is formed on a flexible insulative resin film 21 made of PET etc.. The bottom surface of the feed circuit board 10a is adhered to the radiation plate 20 via a magnetic or insulative adhesive layer 18.

Examples of the sizes are shown here. The thickness of the wireless IC chip 5 is 50 to 100 µm, the thickness of the solder bumps 6 is about 20 µm, the thickness of the feed circuit board 10a is 200 to 500 µm, the thickness of the adhesive layer 18 is 0.1 to 10 µm, the thickness of the radiation plate 20 is 1 to 50 µm, and the thickness of the film 21 is 10 to 100 µm. The wireless IC chip 5 can have various sizes (areas), such as 0.4 mm x 0.4 mm or 0.9 mm x 0.8 mm. The feed circuit board 10a can have a size (area) from the same size as that of the wireless IC chip 5 to a size of 3 mm x 3 mm.

Fig. 3 illustrates an equivalent circuit of the wireless IC device 1a. In the wireless IC device 1a, the radiation plate 20 receives a high-frequency signal (for example, in a UHF frequency band) radiated from a reader-writer (not shown), the feed circuit 16 (the LC series resonant circuit composed of the inductance element L and the capacitance elements C1 and C2) mainly magnetically coupled to the radiation plate 20 is resonated, and only a reception signal having a predetermined frequency is supplied to the wireless IC chip 5. Reversely, after an energy of a certain amount is extracted from the reception signal and the information stored in the wireless IC chip 5 is matched to a predetermined frequency by the feed circuit 16 by using the extracted energy as a drive power, a transmission signal is supplied from the inductance element L in the feed circuit 16 to the radiation plate 20 through the magnetic coupling and the transmission signal is transmitted and transferred from the radiation plate 20 to the reader-writer.

Although the feed circuit 16 is mainly coupled to the radiation plate 20 via the magnetic field, the connection via the electric field may also exist between the feed circuit 16 and the radiation plate 20 (electromagnetic coupling).

In the wireless IC device 1a according to the first embodiment, the wireless IC chip 5 is directly DC-connected to the feed circuit board 10a including the feed circuit 16 and the feed circuit board 10a has approximately the same area as that of the wireless IC chip 5 and is rigid. Accordingly, it is possible to more accurately position and mount the wireless IC chip 5, compared with a case where the wireless IC chip 5 is mounted on a large flexible film as in a conventional wireless IC device. In addition, since the feed circuit board 10a is made of a magnetic ceramic material and has a heat resisting property, the wireless IC chip 5 can be fixed on the feed circuit board 10a with solder. In other words, since an ultrasonic bonding method is not used, unlike conventional cases, it is possible to manufacture the wireless IC chip 5 inexpensively and the wireless IC chip 5 is possibly prevented from being damaged by the pressure applied in the ultrasonic bonding. In addition, a self-alignment effect due to solder reflow can be used.

In the feed circuit 16, the resonant circuit composed of the inductance element L and the capacitance elements C1 and C2 determines the resonant frequency characteristics. The resonant frequency of a signal radiated from the radiation plate 20 substantially corresponds to the self-resonant frequency of the feed circuit 16, and the maximum gain of the signal is substantially determined by at least one of the size of the feed circuit 16, the shape thereof, the distance between the feed circuit 16 and the radiation plate 20, and the medium therebetween. Specifically, according to the first embodiment, the electrical length of the radiation plate 20 is half of a resonant frequency λ. However, the electrical length of the radiation plate 20 may not be half of the resonant frequency λ. Specifically, since the frequency of a signal radiated from the radiation plate 20 is substantially determined by the resonant frequency of the resonant circuit (the feed circuit 16) in the present invention, the frequency characteristics do not substantially depend on the electrical length of the radiation plate 20. It is preferred that the electrical length of the radiation plate 20 be an integer multiple of λ/2 because the gain is maximized in this case.

As described above, since the resonant frequency characteristics of the feed circuit 16 are determined by the resonant circuit composed of the inductance element L and the capacitance elements C1 and C2 included in the feed circuit board 10a, the resonant frequency characteristics are not varied even if the wireless IC device 1a is sandwiched between a book. Even if the wireless IC device 1a is curled to vary the shape of the radiation plate 20 or to vary the size of the radiation plate 20, the resonant frequency characteristics are not varied. Since the winding axis of the coil electrode pattern composing the inductance element L is formed so as to be parallel to the radiation plate 20, the coil electrode pattern has the advantage of the center frequency that is not varied. Since the capacitance elements C1 and C2 are provided downstream of the wireless IC chip 5, a low-frequency surge can be blocked by the capacitance elements C1 and C2 to protect the wireless IC chip 5 from the surge.

In addition, since the feed circuit board 10a is a rigid multilayer board, it is helpful for the processing when the wireless IC chip 5 is soldered to the feed circuit board 10a. Furthermore, since the radiation plate 20 is formed of a flexible metal film held on the flexible film 21, the radiation plate 20 can be adhered to a soft bag made of a plastic film or a cylindrical body, such as a PET bottle, without problem.

According to the present invention, the resonant circuit may also serve as a matching circuit for matching the impedance of the wireless IC chip to that of the radiation plate. Alternatively, the feed circuit board may further be provided with a matching circuit that is composed of the inductance element and the capacitance elements and that is provided separately from the resonant circuit. The addition of the function of the matching circuit to the resonant circuit tends to complicate the design of the resonant circuit. The provision of the matching circuit separately from the resonant circuit allows the resonant circuit and the matching circuit to be independently designed.

### (Second Embodiment, Refer to Figs. 5 to 7)

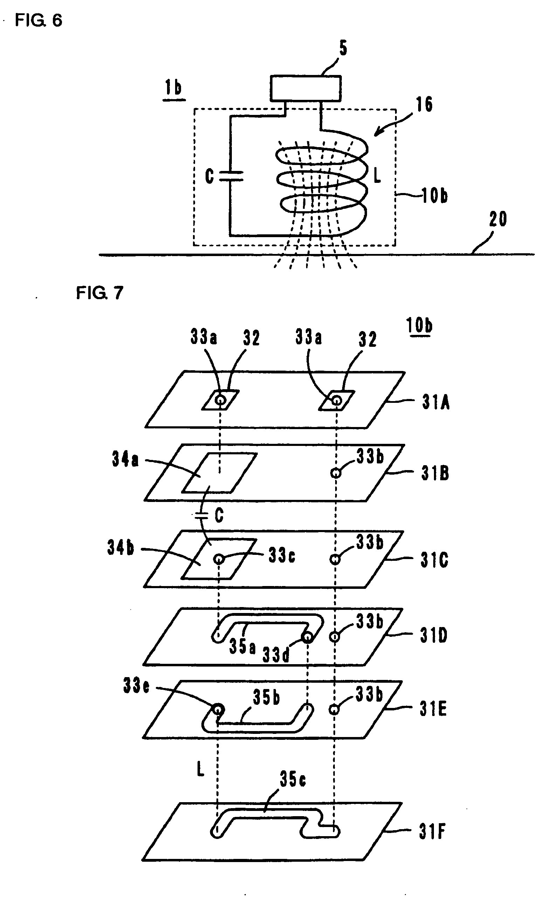

A wireless IC device 1b according to a second embodiment is provided with a monopole type radiation plate, as shown in Fig. 5. The wireless IC device 1b includes the feed circuit 16 that is included in a feed circuit board 10b and that is composed of an LC series resonant circuit including an inductance element L and a capacitance element C. As shown in Fig. 6, the winding axis of the coil electrode pattern composing the inductance element L is perpendicular to the radiation plate 20, and the feed circuit 16 is mainly magnetically coupled to the radiation plate 20.

Specifically, as shown in Fig. 7, the feed circuit board 10b is manufactured by layering, attaching by pressure, and firing ceramic sheets 31A to 31F formed of high-permeability magnetic bodies. The feed circuit board 10b includes the sheet 31A on which connection electrodes 32 and via-hole conductors 33a are formed, the sheet 31B on which a capacitance electrode 34a and a via-hole conductor 33b are formed, the sheet 31C on which a capacitance electrode 34b, the via-hole conductor 33b, and a via-hole conductor 33c are formed, the sheet or sheets 31D on which a conductive pattern 35a, the via-hole conductor 33b, and a via-hole conductor 33d are formed, the sheet or sheets 31E on which a conductive pattern 35b, the via-hole conductor 33b, and a via-hole conductor 33e are formed, and the sheet 31F on which a conductive pattern 35c is formed.

Layering the above ceramic sheets 31A to 31F provides the feed circuit 16 composed of the LC series resonant circuit in which the capacitance element C is connected in series to the helical inductance element L whose winding axis is perpendicular to the radiation plate 20. The capacitance electrode 34a is connected to the connection electrode 32 via the via-hole conductor 33a and is further connected to the wireless IC chip 5 via the solder bump 6. One end of the inductance element L is connected to the connection electrode 32 via the via-hole conductor 33b and is further connected to the wireless IC chip 5 via the solder bump 6.

The effects and advantages of the second embodiment is basically similar to those of the first embodiment. Specifically, in the wireless IC device 1b, the radiation plate 20 receives a high-frequency signal (for example, in a UHF frequency band) radiated from a reader-writer (not shown), the feed circuit 16 (the LC series resonant circuit composed of the inductance element L and the capacitance element C) mainly magnetically coupled to the radiation plate 20 is resonated, and only a reception signal having a predetermined frequency is supplied to the wireless IC chip 5. Reversely, after an energy of a certain amount is extracted from the reception signal and the information stored in the wireless IC chip 5 is matched to a predetermined frequency by the feed circuit 16 by using the extracted energy as a drive power, a transmission signal is supplied from the inductance element L in the feed circuit 16 to the radiation plate 20 through the magnetic coupling and the transmission signal is transmitted and transferred from the radiation plate 20 to the reader-writer.

Particularly, since the winding axis of the coil electrode pattern is perpendicular to the radiation plate 20 in the second embodiment, the component of the magnetic flux toward the radiation plate 20 is increased to improve the transmission efficiency of the signal energy, thus desirably achieving a higher gain.

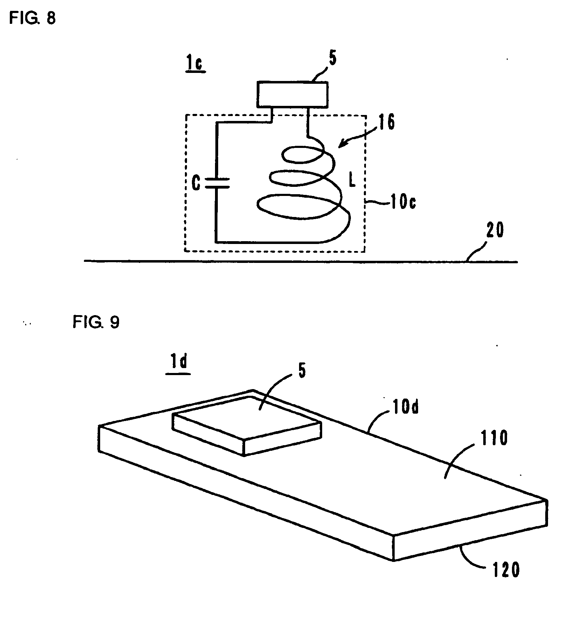

As shown in Fig. 8 as an equivalent circuit, the winding width (the coil diameter) of the coil electrode pattern composing the inductance element L provided in a feed circuit board 10c may be gradually increased toward the radiation plate 20. Since the winding width (the coil diameter) of the coil electrode pattern of the inductance element L is gradually increased toward the radiation plate 20 in the wireless IC device 1c, the transmission efficiency of the signal is improved.

### (Third Embodiment, Refer to Figs. 9 to 13)

In a wireless IC device 1d according to a third embodiment, as shown in Fig. 9, the wireless IC chip 5 is mounted on a first main surface 110 of a feed circuit board 10d composed of a high-permeability magnetic body and a radiation plate (not shown) is provided on a second main surface 120 of the feed circuit board 10d. Fig. 9 shows a wireless-IC-device composite part composed of the wireless IC chip 5 and the feed circuit board 10d.

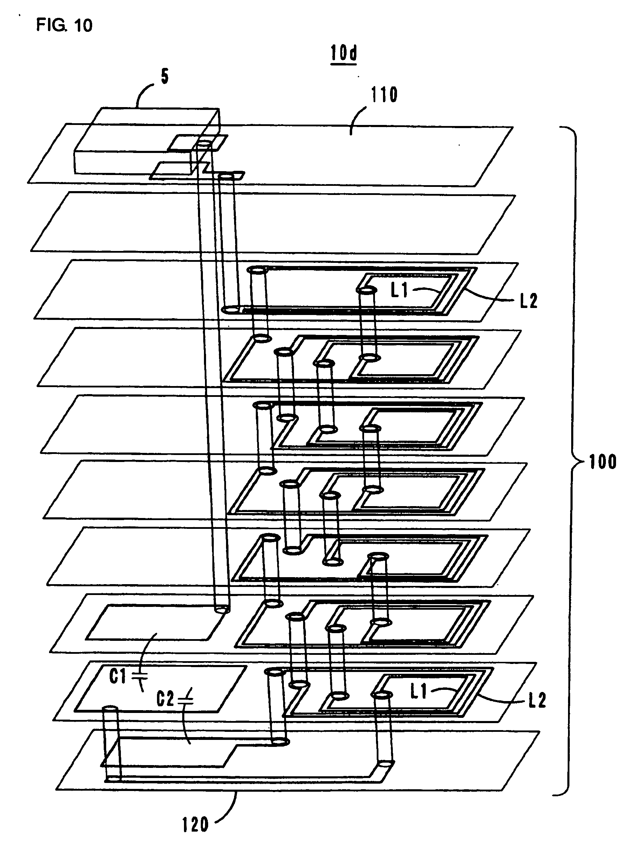

The feed circuit board 10d has a multilayer structure which includes capacitance electrodes composing the capacitance elements C1 and C2 and the inductance elements L1 and L2 and in which high-permeability magnetic layers 100 made of a high-permeability magnetic ceramic material are layered, as shown in Fig. 10.

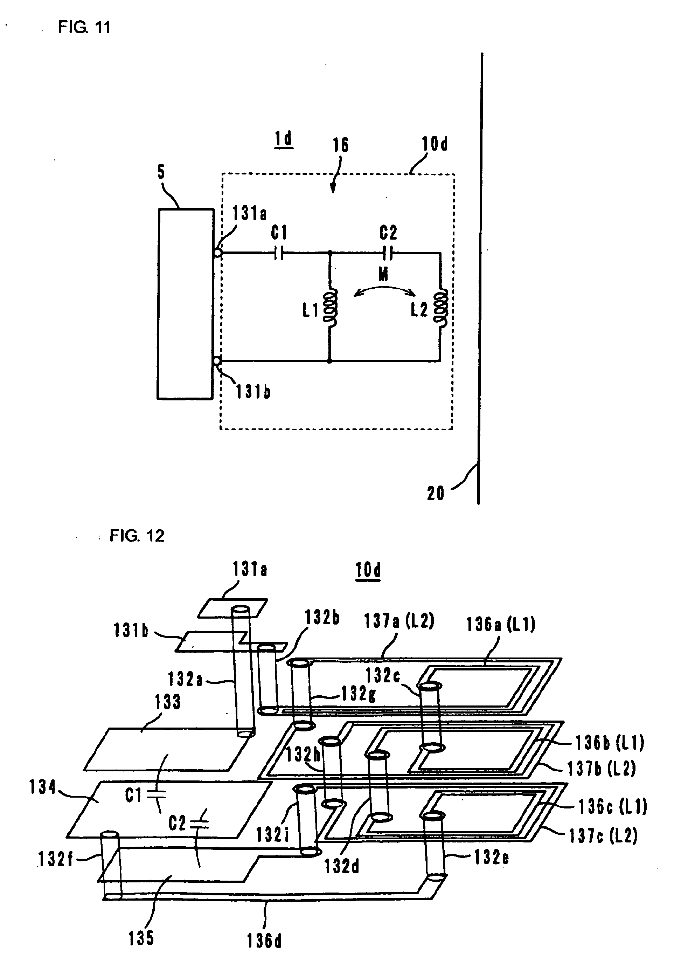

In the wireless IC device 1d, as shown as an equivalent circuit in Fig. 11, the feed circuit 16 includes the inductance elements L1 and L2 magnetically coupled to each other (denoted by reference numeral M). One end of the inductance element L1 is connected to the wireless IC chip 5 via the capacitance element C1 and a connection electrode 131a and is connected to one end of the inductance element L2 via the capacitance element C2. The other end of the inductance element L1 and the other end of the inductance element L2 are connected to the wireless IC chip 5 via a connection electrode 131b. In other words, the feed circuit 16 includes an LC series resonant circuit including the inductance element L1 and the capacitance element C1 and an LC series resonant circuit including the inductance element L2 and the capacitance element C2. Both of the inductance elements L1 and L2 are magnetically coupled to the radiation plate 20.

The feed circuit board 10d will now be described in more detail. As shown in Fig. 12, the connection electrode 131a is connected to a capacitance electrode 133 via a via-hole conductor 132a and the capacitance electrode 133 opposes a capacitance electrode 134 to form the capacitance element C1. The capacitance electrode 134 opposes a capacitance electrode 135 to form the capacitance element C2. The connection electrode 131b is connected to conductive patterns 136a and 137a resulting from bifurcation via a via-hole conductor 132b. The conductive pattern 136a is connected to a conductive pattern 136b via a via-hole conductor 132c, is further connected to a conductive pattern 136c via a via-hole conductor 132d, and is further connected to a conductive pattern 136d via a via-hole conductor 132e. The conductive pattern 136d is connected to the capacitance electrode 134 via a via-hole conductor 132f.

The conductive pattern 137a is connected to a conductive pattern 137b via a via-hole conductor 132g, is further connected to a conductive pattern 137c via a via-hole conductor 132h, and is further connected to the capacitance electrode 135 via a via-hole conductor 132i. The conductive patterns 136a, 136b, and 136c compose the inductance element L1 and the conductive patterns 137a, 137b, and 137c compose the inductance element L2.

The high-permeability magnetic layers made of a high-permeability magnetic ceramic material are not shown in Fig. 12. In addition, three layers of the conductive patterns composing the inductance elements L1 and L2 are shown in Fig. 12 for simplicity.

In the wireless IC device 1d, the radiation plate 20 receives a high-frequency signal (for example, in a UHF frequency band) radiated from a reader-writer (not shown), the feed circuit 16 (including the LC series resonant circuit composed of the inductance element L1 and the capacitance element C1 and the LC series resonant circuit composed of the inductance element L2 and the capacitance element C2) mainly magnetically coupled to the radiation plate 20 is resonated, and only a reception signal having a predetermined frequency is supplied to the wireless IC chip 5. Reversely, after an energy of a certain amount is extracted from the reception signal and the information stored in the wireless IC chip 5 is matched to a predetermined frequency by the feed circuit 16 by using the extracted energy as a drive power, a transmission signal is supplied from the inductance elements L1 and L2 in the feed circuit 16 to the radiation plate 20 through the magnetic coupling and the transmission signal is transmitted and transferred from the radiation plate 20 to the reader-writer.

Particularly, the capacitance electrodes 133, 134, and 135, the inductor conductive patterns 136a to 136c, and the inductor conductive patterns 137a to 137c are provided in parallel to the radiation plate 20 in the third embodiment. Accordingly, the magnetic field generated by the inductor conductive patterns 136a to 136c and the inductor conductive patterns 137a to 137c is not blocked by the capacitance electrodes 133, 134, and 135 and, therefore, the radiation characteristics from the inductor conductive patterns 136a to 136c and the inductor conductive patterns 137a to 137c are improved.

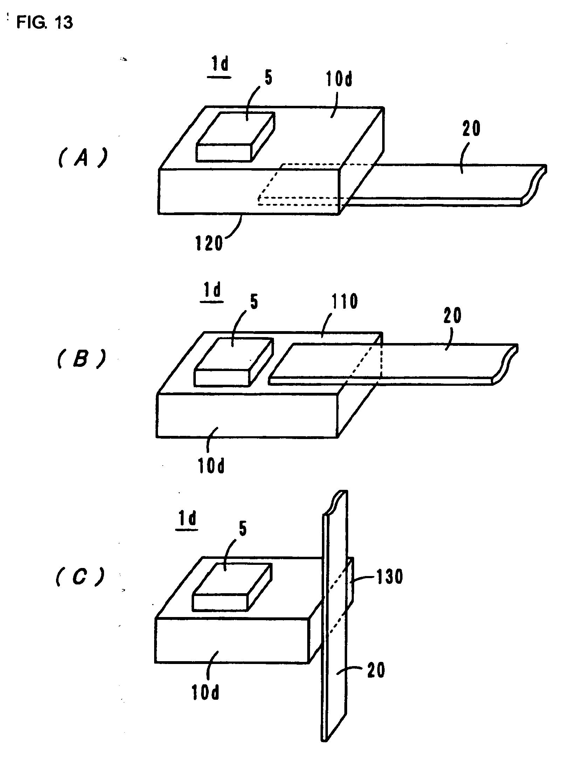

The radiation plate 20 is adhered to the second main surface 120 of the feed circuit board 10d such that one end of the radiation plate 20 opposes the inductor conductive patterns in the third embodiment, as shown in Fig. 13(A). However, as shown in Fig. 13(B), the radiation plate 20 may be adhered to the first main surface 110 such that one end of the radiation plate 20 opposes the inductor conductive patterns. Alternatively, as shown in Fig. 13(C), the radiation plate 20 may be adhered to a side face 130 by which the first main surface 110 and the second main surface 120 are connected.

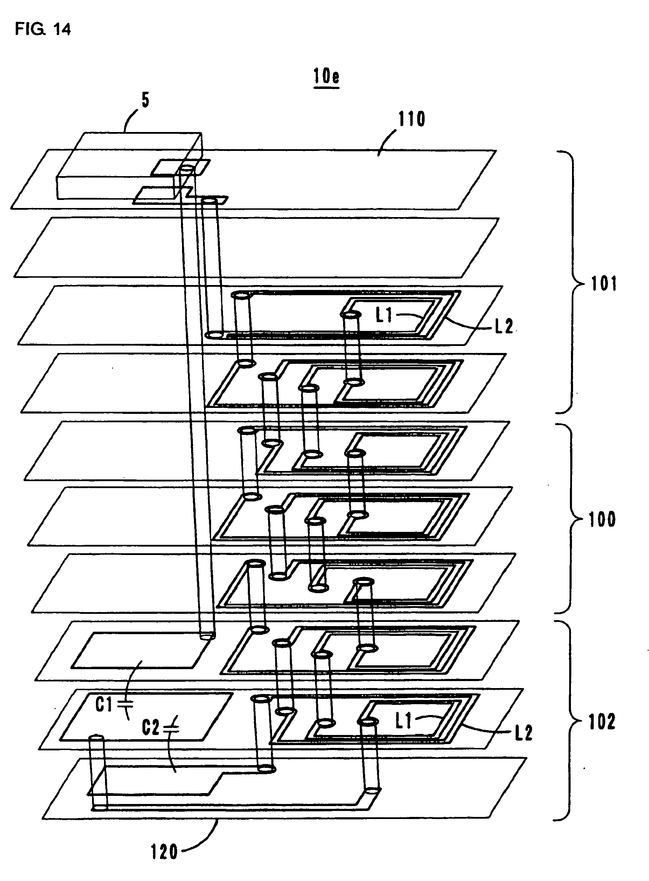

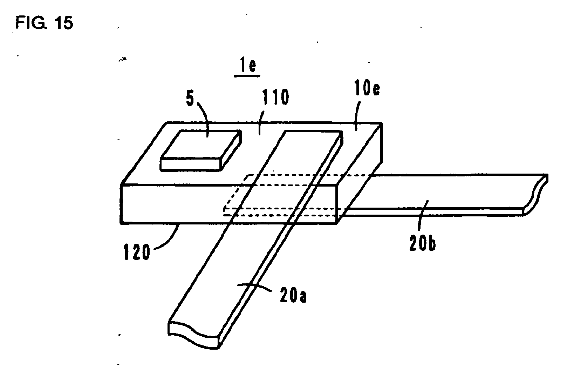

### (Fourth Embodiment, Refer to Figs. 14 and 15)

As shown in Fig. 14, in a wireless IC device 1e according to a fourth embodiment, a feed circuit board 10e has the wireless IC chip 5 on its first main surface 110. The feed circuit board 10e has a multilayer structure in which nonmagnetic layers 101 and 102 made of a low-permeability magnetic ceramic material or a nonmagnetic ceramic material are layered on one side and the other side of the high-permeability magnetic layers 100 made of a high-permeability magnetic ceramic material, respectively. The structure of the capacitance elements C1 and C2 and the inductance elements L1 and L2 and the equivalent circuit composed thereof in the feed circuit board 10e are similar to those in the third embodiment.

As shown in Fig. 15, radiation plates are provided at certain positions on the first main surface 110 and the second main surface 120 of the feed circuit board 10e as radiation plates 20a and 20b, respectively. The direction in which the radiation plate 20a extends may be orthogonal to the direction in which the radiation plate 20b extends, as shown in Fig. 15.

In the feed circuit board 10e, the first-main-surface-side winding part and the second-main-surface-side winding part, among the inductor conductive patterns composing the inductance elements L1 and L2, are formed in the nonmagnetic layers 101 and 102, respectively. Accordingly, the magnetic flux generated by the inductor conductive patterns efficiently propagates to the radiation plates 20a and 20b via the nonmagnetic layers 101 and 102 to increase the gain. In addition, since the capacitance elements C1 and C2 are formed in the nonmagnetic layers 102, it is possible to form the capacitance elements having higher capacitances if the layers have a higher permittivity.

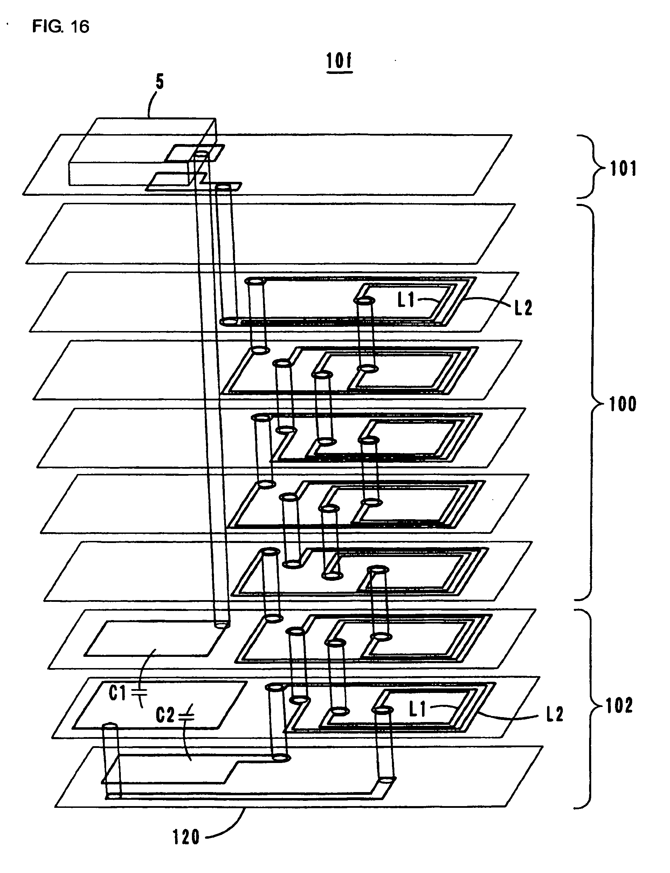

### (Fifth Embodiment, Refer to Figs. 16 to 18)

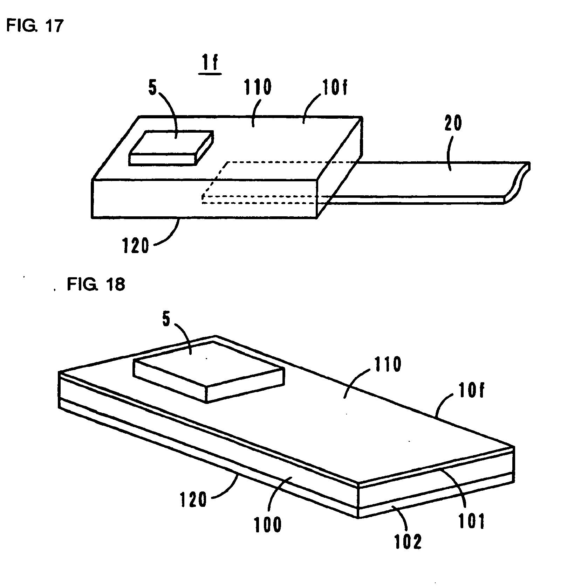

As shown in Figs. 16 and 18, in a wireless IC device 1f according to a fifth embodiment, a feed circuit board 10f has the wireless IC chip 5 on its first main surface 110. The feed circuit board 10f has a multilayer structure in which nonmagnetic layers 101 and 102 made of a low-permeability magnetic ceramic material or a nonmagnetic ceramic material are layered on one side and the other side of the high-permeability magnetic layers 100 made of a high-permeability magnetic ceramic material, respectively. The structure of the capacitance elements C1 and C2 and the inductance elements L1 and L2 and the equivalent circuit composed thereof in the feed circuit board 10f are similar to those in the third embodiment. The radiation plate 20 is provided at a certain position on the second main surface 120 of the feed circuit board 10f, as shown in Fig. 17.

In the feed circuit board 10f, the second-main-surface-side winding part, among the inductor conductive patterns composing the inductance elements L1 and L2, is formed in the nonmagnetic layers 102. Although the nonmagnetic layer 101 is provided at the side of the first main surface 110, no inductor conductive pattern is formed in the nonmagnetic layer 101. Accordingly, the magnetic flux generated by the inductor conductive patterns is reflected from the side of the nonmagnetic layer 101 due to the difference in the permeability and efficiently propagates to the radiation plate 20 via the nonmagnetic layers 102 to increase the gain. In other words, such a structure provides the directivity (the directivity to the second main surface) to the magnetic flux. In addition, since the capacitance elements C1 and C2 are formed in the nonmagnetic layers 102, it is possible to form the capacitance elements having higher capacitances if the layers have a higher permittivity.

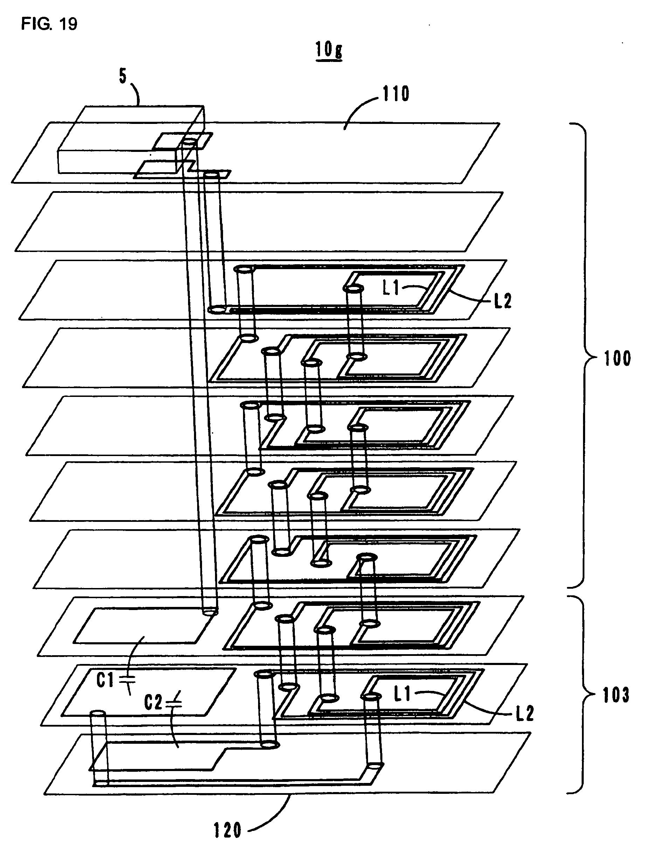

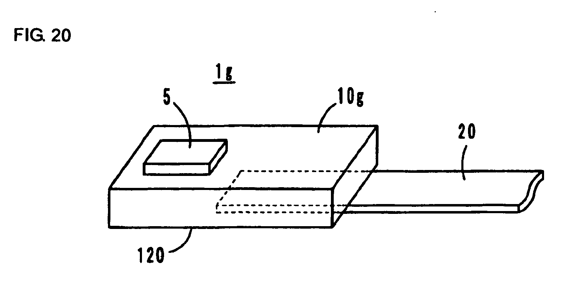

### (Sixth Embodiment, Refer to Figs. 19 and 20)

As shown in Fig. 19, in a wireless IC device 1g according to a sixth embodiment, a feed circuit board 10g has the wireless IC chip 5 on its first main surface 110. The feed circuit board 10g has a multilayer structure in which nonmagnetic layers 103 made of a low-permeability magnetic ceramic material or a nonmagnetic ceramic material are layered on one side of the high-permeability magnetic layers 100 made of a high-permeability magnetic ceramic material. The structure of the capacitance elements C1 and C2 and the inductance elements L1 and L2 and the equivalent circuit composed thereof in the feed circuit board 10g are similar to those in the third embodiment. The radiation plate 20 is provided at a certain position on the second main surface 120 of the feed circuit board 10g, as shown in Fig. 20.

In the feed circuit board 10g, the second-main-surface-side winding part, among the inductor conductive patterns composing the inductance elements L1 and L2, is formed in the nonmagnetic layers 103. Accordingly, the magnetic flux generated by the inductor conductive patterns efficiently propagates to the radiation plate 20 via the nonmagnetic layers 103 at the side of the second main surface 120 to increase the gain. The magnetic flux generated by the inductor conductive patterns is trapped in the high-permeability magnetic layers 100 at the side of the first main surface 110. In other words, such a structure provides the directivity (the directivity to the second main surface) to the magnetic flux. In addition, since the most part of the inductor conductive patterns is formed in the high-permeability magnetic layers 100, the Q value of the inductance elements is increased. Accordingly, even if the inductance elements are reduced in size, the inductance elements having sufficient inductances are provided to achieve stable frequency characteristics. Furthermore, since the capacitance elements C1 and C2 are formed in the nonmagnetic layers 103, it is possible to form the capacitance elements having higher capacitances if the layers have a higher permittivity.

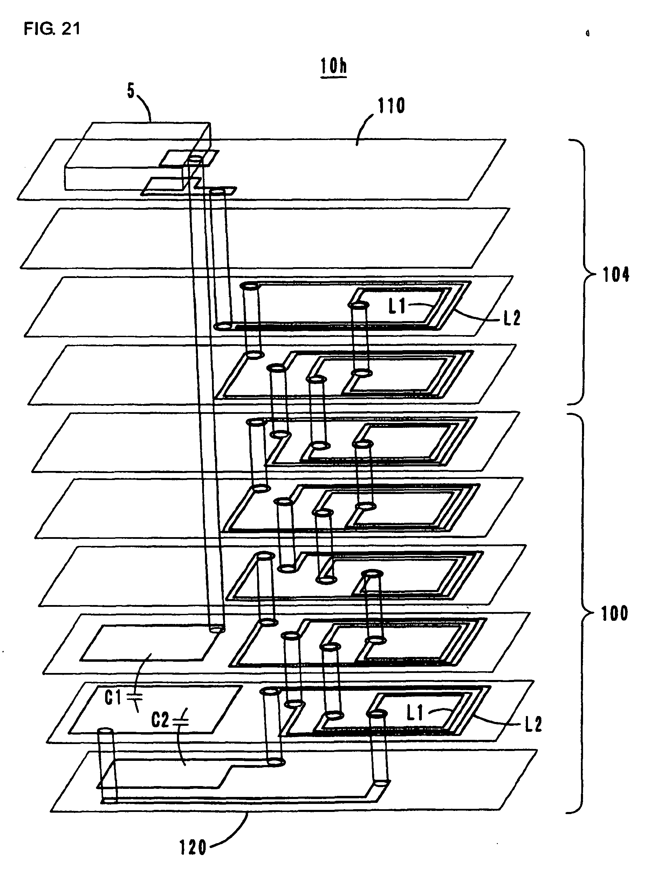

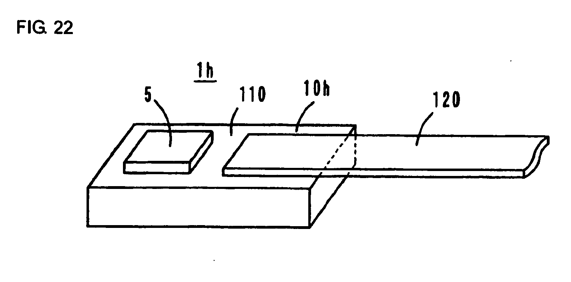

### (Seventh Embodiment, Refer to Figs. 21 and 22)

As shown in Fig. 21, in a wireless IC device 1h according to a seventh embodiment, a feed circuit board 10h has the wireless IC chip 5 on its first main surface 110. The feed circuit board 10h has a multilayer structure in which nonmagnetic layers 104 made of a low-permeability magnetic ceramic material or a nonmagnetic ceramic material are layered on the other side of the high-permeability magnetic layers 100 made of a high-permeability magnetic ceramic material. The structure of the capacitance element C1 and C2 and the inductance elements L1 and L2 and the equivalent circuit composed thereof in the feed circuit board 10h are similar to those in the third embodiment. The radiation plate 20 is provided at a certain position on the first main surface 110 of the feed circuit board 10h, as shown in Fig. 22.

In the feed circuit board 10h, the first-main-surface-side winding part, among the inductor conductive patterns composing the inductance elements L1 and L2, is formed in the nonmagnetic layers 104. Accordingly, the magnetic flux generated by the inductor conductive patterns efficiently propagates to the radiation plate 20 via the nonmagnetic layers 104 at the side of the first main surface 110 to increase the gain. The magnetic flux generated by the inductor conductive patterns is trapped in the high-permeability magnetic layers 100 at the side of the second main surface 120. In other words, such a structure provides the directivity (the directivity to the first main surface) to the magnetic flux.

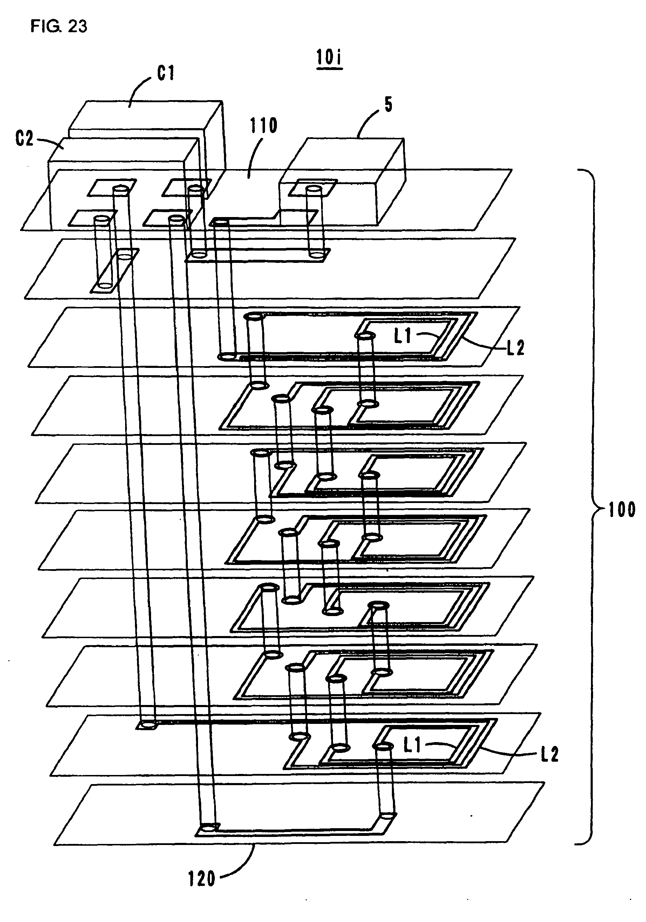

### (Eighth Embodiment, Refer to Figs. 23 to 25)

As shown in Fig. 23, in a wireless IC device 1i according to an eighth embodiment, a feed circuit board 10i has the wireless IC chip 5 on its first main surface 110. The feed circuit board 10i has a multilayer structure in which multiple high-permeability magnetic layers 100 made of a high-permeability magnetic ceramic material are layered. The equivalent circuit composed of the capacitance elements C1 and C2 and the inductance elements L1 and L2 in the feed circuit board 10i is similar to that in the third embodiment. The radiation plate, although not shown, can be formed at an arbitrary position on the first main surface, the second main surface, or the side face, as in the third embodiment.

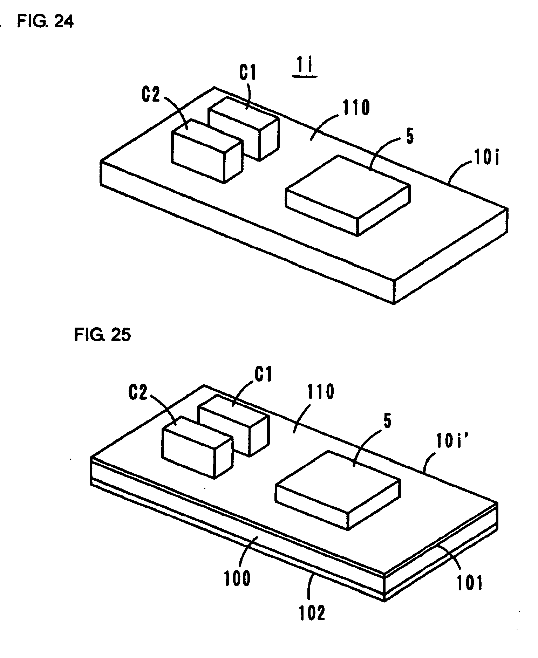

As shown in Figs. 23 and 24, the capacitance elements C1 and C2 are composed as a surface mount device including chip ceramic capacitors in the feed circuit board 10i. Composing the capacitance elements as the surface mount device allows the degree of freedom of selection of capacitances to be increased, so that it is possible to respond to even a case where higher capacitances are required.

In addition, even in the case where the capacitance elements are composed as the surface mount device, it is possible to apply a feed circuit board having a multilayer structure in which the high-permeability magnetic layers 100 and the nonmagnetic layers 101 and 102 are layered, as in a feed circuit board 10i' shown in Fig. 25.

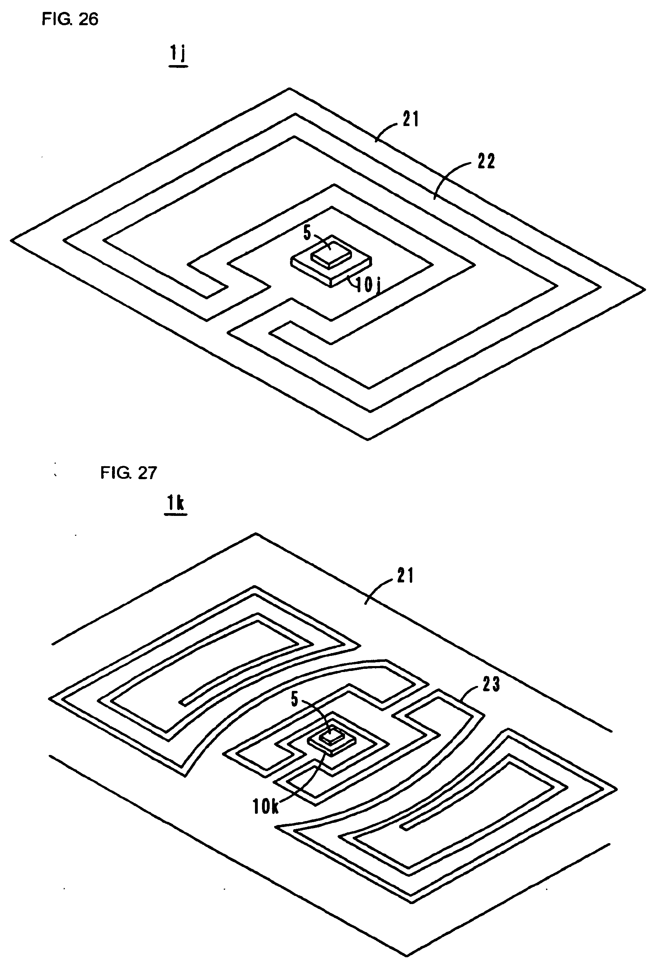

### (Ninth Embodiment, Refer to Fig. 26)

In a wireless IC device 1j according to a twenty-sixth embodiment, as shown in Fig. 26, a radiation plate 22 having a duplicate closed-loop shape is symmetrically provided on the surface of the resin film 21 and a feed circuit board 10j on which the wireless IC chip 5 is mounted is arranged at the central part of the inner loop of the radiation plate 22. Any of the feed circuit boards 10a to 10h described above can be used as the feed circuit board 10j.

In the ninth embodiment, the feed circuit board 10j is not adhered to the radiation plate 22 and is arranged adjacent to the radiation plate 22. Since the radiation plate 22 has a loop shape, the linear length of the radiation plate 22 is decreased. Even in this structure, the feed circuit board 10j is magnetically coupled to the radiation plate 22, so that signals can be exchanged in the same manner as in the above embodiments and the communication with a reader-writer can be established. It is sufficient for the feed circuit board 10j to be arranged at the substantially central part of the radiation plate 22 and to have a positional accuracy that is not so high.

### (Tenth Embodiment, Refer to Fig. 27)

In a wireless IC device 1k according to a tenth embodiment, as shown in Fig. 27, a radiation plate 23 having a shape resulting from a combination of meander, loop, and spiral patterns is symmetrically provided on the surface of the resin film 21 and a feed circuit board 10k on which the wireless IC chip 5 is mounted is arranged at the central part of the inner loop of the radiation plate 23. Any of the feed circuit boards 10a to 10h described above can be used as the feed circuit board 10k.

Also in the tenth embodiment, the feed circuit board 10k is not adhered to the radiation plate 23 and is arranged adjacent to the radiation plate 23. Since the radiation plate 23 has a shape resulting from a combination of meander, loop, and spiral patterns, the linear length of the radiation plate 23 is decreased. Even in this structure, the feed circuit board 10k is magnetically coupled to the radiation plate 23, so that signals can be exchanged in the same manner as in the above embodiments and the communication with a reader-writer can be established. As in the ninth embodiment, it is sufficient for the feed circuit board 10k to be arranged at a positional accuracy that is not so high.

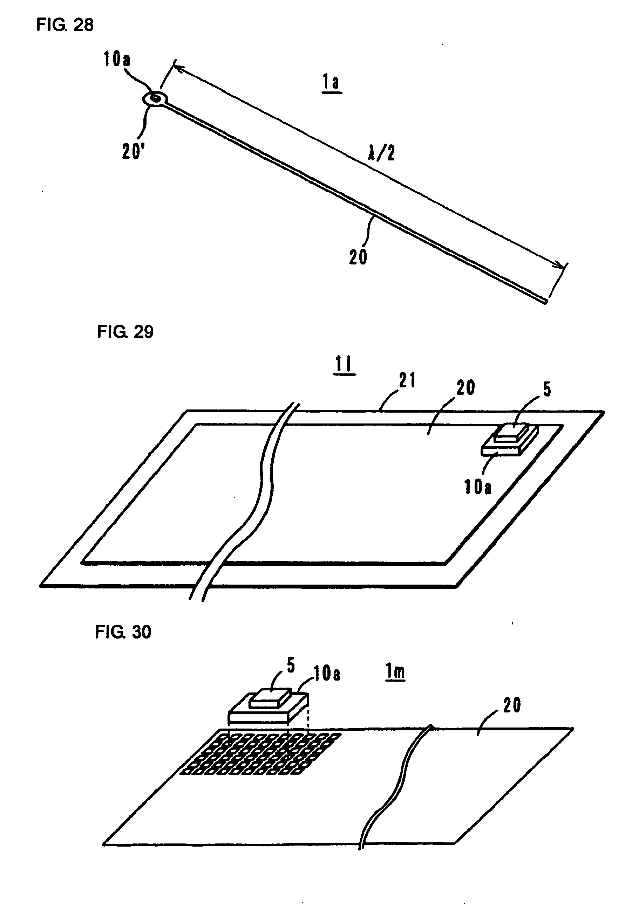

### (First Application, Refer to Fig. 28)

In a first application of the wireless IC device 1a, as shown in Fig. 28, the radiation plate 20 has a long shape and it is preferred that the area of a part 20' where the feed circuit board 10a is adhered to the radiation plate 20 be larger than that of the board 10a. Such a structure does not require a strict positional accuracy when the feed circuit board 10a is adhered to the radiation plate 20 and stable electrical characteristics are achieved. The remaining structure of the wireless IC device 1a, that is, the internal structure of the feed circuit board 10a is the same as in the first embodiment.

### (Second Application, Refer to Fig. 29)

In a wireless IC device 11 according to a second application, as shown in Fig. 29, the large radiation plate 20 made of, for example, an aluminum foil is formed on the large flexible insulative resin film 21. The feed circuit board 10a on which the wireless IC chip 5 is mounted is adhered to an arbitrary position on the radiation plate 20.

The remaining structure of the wireless IC device 11, that is, the internal structure of the feed circuit board 10a is the same as in the first embodiment. Accordingly, the effects and advantages of the second application are basically similar to those of the first embodiment. In addition, the second application has the advantage in that it is sufficient for the feed circuit board 10a to be adhered at a positional accuracy that is not so high.

### (Third Application, Refer to Fig. 30)

In a wireless IC device 1m according to a third application, as shown in Fig. 30, the large radiation plate 20 made of, for example, an aluminum foil is subjected to mesh division. The mesh may be formed on the entire radiation plate 20 or may be partially formed on the radiation plate 20.

The remaining structure of the wireless IC device 1m is the same as in the first embodiment. Since the magnetic flux of the coil electrode pattern escapes from the openings in the mesh, in addition to the advantage that it is sufficient for the feed circuit board 10a to be adhered at a positional accuracy that is not so high, the variation (decrease) of the magnetic flux generated from the feed circuit board 10a is reduced and, therefore, the magnetic flux of a larger amount passes thorough the radiation plate 20. Consequently, it is possible to improve the transmission efficiency of the signal energy and to reduce the shift in frequency due to the adherence.

### (Fourth Application, Refer to Fig. 31)

In a wireless IC device In according to a fourth application, as shown in Fig. 31, a radiation plate 20c is winded in a spiral shape. The radiation plate may have a spiral shape in the present invention. In this case, the increase in the inductance of the radiation plate can be used to increase the gain in the relatively small area.

### Industrial Applicability

As described above, the present invention is useful for the wireless IC device and, particularly, is excellent in stable frequency characteristics.

## Claims

1. A wireless-IC-device composite part comprising:
a wireless IC chip (5); and
a feed circuit board (10a - 10i) having the wireless IC chip (5) connected thereto and including a feed circuit including an inductance element (L; L1, L2),
wherein a first body made of a high-permeability magnetic material is formed in at least part of the feed circuit board (10a - 10i) and at least part of the inductance element (L; L1, L2) is provided in the first body,
the composite part is **characterized in that** it comprises
a second body (101; 102; 103; 104) made of a low-permeability magnetic material or a nonmagnetic material is formed in the feed circuit board (10e - 10g), and
wherein a winding part of the inductance element, is formed in the second body.

2. A wireless IC device comprising:
a wireless-IC-device composite part according to claim 1; and
a radiation plate (20; 20a, 20b; 120; 22; 23) electromagnetically coupled to the inductance element (L; L1, L2) in the feed circuit (10a -10i).

3. The wireless IC device according to Claim 2,
wherein the inductance element (L; L1, L2) is formed of a coil inductor pattern, and
wherein the inductor pattern is formed on the feed circuit board (10b; 10c) such that the winding axis of the inductor pattern is perpendicular to the radiation plate (20).

4. The wireless IC device according to Claim 2,
wherein the inductance element (L) is formed of a coil inductor pattern, and
wherein the inductor pattern is formed on the feed circuit board (10a) such that the winding axis of the inductor pattern is parallel to the radiation plate.

5. The wireless IC device according to any of Claims 2 to 4,
wherein the feed circuit (10a - 10i) includes the inductance element (L; L1, L2) and a capacitance element (C, C1, C2) that compose an LC resonant circuit having a predetermined resonant frequency.

6. The wireless IC device according to Claim 5,
wherein the feed circuit includes a plurality of LC resonant circuits.

7. The wireless IC device according to Claim 2 or 6,
wherein the capacitance element (C; C1, C2) is included in the feed circuit board as a capacitor pattern.

8. The wireless IC device according to Claim 5 or 6,
wherein the capacitance element (C1, C2) is mounted on the feed circuit board (10i) as a surface mount device.

9. The wireless IC device according to any of Claims 5 to 8,
wherein the capacitance element (C; C1, C2) is provided downstream of the wireless IC chip (5) and is arranged between the wireless IC chip (5) and the inductance element (L).

10. The wireless IC device according to any of Claims 7 to 9,
wherein the capacitor pattern and the inductor pattern are arranged in parallel to and adjacent to the radiation plate (20).

11. The wireless IC device according to any of Claims 2 to 10,
wherein the radiation plate (20; 20a, 20b; 120; 22; 23) is made of a magnetic metal material.

12. The wireless IC device according to any of Claims 2 to 11,
wherein the feed circuit board (10a - 10i) is a ceramic multilayer board in which a plurality of ceramic layers are layered.

13. The wireless IC device according to any of Claims 2 to 12,
wherein the feed circuit board (10a - 10i) is a rigid board and the radiation plate (20; 20a, 20b; 120; 22; 23) is formed of a flexible metal film.

14. The wireless IC device according to Claim 13,
wherein the flexible metal film is held on a flexible resin film.

15. The wireless IC device according to any of Claims 2 to 14,
wherein the electrical length of the radiation plate (20; 20a, 20b; 120; 22; 23) is an integer multiple of a half-wavelength of the resonant frequency.

## Patentansprüche

1. Ein zusammengesetztes drahtloses IC-Vorrichtungsteil, das folgende Merkmale umfasst:
einen drahtlosen IC-Chip (5); und
eine Versorgungsschaltungsplatine (10a-10i), mit der der drahtlose IC-Chip (5) verbunden ist, und die eine Versorgungsschaltung umfasst, die ein Induktivitätselement (L; L1, L2) umfasst,
wobei ein erster Körper, der aus einem Magnetmaterial mit hoher Permeabilität hergestellt ist, in zumindest einem Teil der Versorgungsschaltungsplatine (10a-10i) gebildet ist, und zumindest ein Teil des Induktivitätselements (L; L1, L2) in dem ersten Körper vorgesehen ist,
wobei das zusammengesetzte Teil **dadurch gekennzeichnet ist, dass** es folgende Merkmale umfasst:
einen zweiten Körper (101; 102; 103; 104), der aus einem Magnetmaterial mit geringer Permeabilität oder einem nichtmagnetischen Material hergestellt ist, der in der Versorgungsschaltungsplatine (10e-10g) gebildet ist, und
wobei ein Wicklungsteil des Induktivitätselements in dem zweiten Körper gebildet ist.

2. Eine drahtlose IC-Vorrichtung, die folgende Merkmale umfasst:
ein zusammengesetztes drahtloses IC-Vorrichtungsteil gemäß Anspruch 1; und
eine Strahlungsplatte (20; 20a, 20b; 120; 22; 23), die in der Versorgungsschaltung (10a-10i) elektromagnetisch mit dem Induktivitätselement (L; L1, L2) gekoppelt ist.

3. Die drahtlose IC-Vorrichtung gemäß Anspruch 2, bei der das Induktivitätselement (L; L1, L2) aus einer Spuleninduktorstruktur gebildet ist, und
bei der die Induktorstruktur auf der Versorgungsschaltungsplatine (10b; 10c) gebildet ist, so dass die Wicklungsachse der Induktorstruktur senkrecht zu der Strahlungsplatte (20) ist.

4. Die drahtlose IC-Vorrichtung gemäß Anspruch 2,
bei der das Induktivitätselement (L) aus einer Spuleninduktorstruktur gebildet ist, und
bei der die Induktorstruktur auf der Versorgungsschaltungsplatine (10a) gebildet ist, so dass die Wicklungsachse der Induktorstruktur parallel zu der Strahlungsplatte ist.

5. Die drahtlose IC-Vorrichtung gemäß einem der Ansprüche 2 bis 4, bei der die Versorgungsschaltung (10a-10i) das Induktivitätselement (L; L1, L2) und ein Kapazitätselement (C, C1, C2) umfasst, die eine LC-Resonanzschaltung bilden, die eine vorbestimmte Resonanzfrequenz aufweist.

6. Die drahtlose IC-Vorrichtung gemäß Anspruch 5, bei der die Versorgungsschaltung eine Mehrzahl von LC-Resonanzschaltungen umfasst.

7. Die drahtlose IC-Vorrichtung gemäß Anspruch 2 oder 6, bei der das Kapazitätselement (C; C1, C2) als eine Kondensatorstruktur in der Versorgungsschaltungsplatine enthalten ist.

8. Die drahtlose IC-Vorrichtung gemäß Anspruch 5 oder 6, bei der das Kapazitätselement (C1, C2) als Oberflächenbefestigungsvorrichtung auf der Versorgungsschaltungsplatine (10i) befestigt ist.

9. Die drahtlose IC-Vorrichtung gemäß einem der Ansprüche 5 bis 8,
bei der das Kapazitätselement (C; C1, C2) nachgeschaltet zu dem drahtlosen IC-Chip (5) vorgesehen ist und zwischen dem drahtlosen IC-Chip (5) und dem Induktivitätselement (L) angeordnet ist.

10. Die drahtlose IC-Vorrichtung gemäß einem der Ansprüche 7 bis 9, bei der die Kondensatorstruktur und die Induktorstruktur parallel und benachbart zu der Strahlungsplatte (20) angeordnet sind.

11. Die drahtlose IC-Vorrichtung gemäß einem der Ansprüche 2 bis 10, bei der die Strahlungsplatte (20; 20a, 20b; 120; 22; 23) aus einem magnetischen Metallmaterial hergestellt ist.

12. Die drahtlose IC-Vorrichtung gemäß einem der Ansprüche 2 bis 11, bei der die Versorgungsschaltungsplatine (10a-10i) eine Keramikmehrschichtplatine ist, in der eine Mehrzahl von Keramikschichten geschichtet sind.

13. Die drahtlose IC-Vorrichtung gemäß einem der Ansprüche 2 bis 12, bei der die Versorgungsschaltungsplatine (10a-10i) eine starre Platine ist und die Strahlungsplatte (20; 20a, 20b; 120; 22; 23) aus einem flexiblen Metallfilm gebildet ist.

14. Die drahtlose IC-Vorrichtung gemäß Anspruch 13, bei der der flexible Metallfilm auf einem flexiblen Harzfilm gehalten wird.

15. Die drahtlose IC-Vorrichtung gemäß einem der Ansprüche 2 bis 14, bei der die elektrische Länge der Strahlungsplatte (20; 20a, 20b; 120; 22; 23) ein ganzzahliges Mehrfaches einer Halbwellenlänge der Resonanzfrequenz ist.

## Revendications

1. Partie composite de dispositif IC sans fil comprenant :
une puce IC sans fil (5) ; et
une carte de circuit d'alimentation (10a - 10i) ayant la puce IC sans fil (5) connectée à celle-ci et incluant un circuit d'alimentation incluant un élément d'inductance (L ; L1, L2),
dans laquelle un premier corps constitué d'un matériau magnétique à perméabilité élevée est formé dans au moins une partie de la carte de circuit d'alimentation (10a - 10i) et au moins une partie de l'élément d'inductance (L ; L1, L2) est pourvue dans le premier corps,
la partie composite est **caractérisée en ce qu'**elle comprend un second corps (101 ; 102 ; 103 ; 104) constitué d'un matériau magnétique à faible perméabilité ou d'un matériau non magnétique qui est formé dans la carte de circuit d'alimentation (10e - 10g), et
dans laquelle une partie d'enroulement de l'élément d'inductance est formée dans le second corps.

2. Dispositif IC sans fil comprenant :
une partie composite de dispositif IC sans fil selon la revendication 1 ; et
une plaque de rayonnement (20 ; 20a, 20b ; 120 ; 22 ; 23) couplée électromagnétiquement à l'élément d'inductance (L ; L1, L2) dans le circuit d'alimentation (10a - 10i).

3. Dispositif IC sans fil selon la revendication 2,
dans lequel l'élément d'inductance (L ; L1, L2) est formé d'un motif d'inducteur de bobine, et
dans lequel le motif d'inducteur est formé sur la carte de circuit d'alimentation (10b ; 10c) de sorte que l'axe d'enroulement du motif d'inducteur soit perpendiculaire à la plaque de rayonnement (20).

4. Dispositif IC sans fil selon la revendication 2, dans lequel l'élément d'inductance (L) est formé d'un motif d'inducteur de bobine, et
dans lequel le motif d'inducteur est formé sur la carte de circuit d'alimentation (10a) de sorte que l'axe d'enroulement du motif d'inducteur soit parallèle à la plaque de rayonnement.

5. Dispositif IC sans fil selon l'une quelconque des revendications 2 à 4,
dans lequel le circuit d'alimentation (10a - 10i) inclut l'élément d'inductance (L ; L1, L2) et un élément de capacité (C ; C1, C2) qui composent un circuit résonnant LC ayant une fréquence de résonance prédéterminée.

6. Dispositif IC sans fil selon la revendication 5,
dans lequel le circuit d'alimentation inclut une pluralité de circuits résonnants LC.

7. Dispositif IC sans fil selon la revendication 2 ou 6,
dans lequel l'élément de capacité (C ; C1, C2) est inclus dans la carte de circuit d'alimentation comme un motif de condensateur.

8. Dispositif IC sans fil selon la revendication 5 ou 6,
dans lequel l'élément de capacité (C1, C2) est monté sur la carte de circuit d'alimentation (10i) comme un composant pour montage en surface.

9. Dispositif IC sans fil selon l'une quelconque des revendications 5 à 8,
dans lequel l'élément de capacité (C ; C1, C2) est pourvu en aval de la puce IC sans fil (5) et est agencé entre la puce IC sans fil (5) et l'élément d'inductance (L).

10. Dispositif IC sans fil selon l'une quelconque des revendications 7 à 9,
dans lequel le motif de condensateur et le motif d'inducteur sont agencés en parallèle à et adjacents à la plaque de rayonnement (20).

11. Dispositif IC sans fil selon l'une quelconque des revendications 2 à 10,
dans lequel la plaque de rayonnement (20 ; 20a, 20b ; 120 ; 22 ; 23) est constituée d'un matériau métallique magnétique.

12. Dispositif IC sans fil selon l'une quelconque des revendications 2 à 11,
dans lequel la carte de circuit d'alimentation (10a - 10i) est une carte multicouche céramique dans laquelle une pluralité de couches céramiques sont stratifiées.

13. Dispositif IC sans fil selon l'une quelconque des revendications 2 à 12,
dans lequel la carte de circuit d'alimentation (10a - 10i) est une carte rigide et la plaque de rayonnement (20 ; 20a, 20b ; 120 ; 22 ; 23) est formée d'un film métallique flexible.

14. Dispositif IC sans fil selon la revendication 13,
dans lequel le film métallique flexible est maintenu sur un film en résine flexible.

15. Dispositif IC sans fil selon l'une quelconque des revendications 2 à 14,
dans lequel la longueur électrique de la plaque de rayonnement (20 ; 20a, 20b ; 120 ; 22 ; 23) est un entier multiple d'une demi-longueur d'onde de la fréquence de résonance.
